(19) **Europäisches Patentamt / European Patent Office / Office européen des brevets**

(11) **EP 4 445 685 B1**

(12) **FASCICULE DE BREVET EUROPEEN**

(45) Date de publication et mention de la délivrance du brevet:
**22.10.2025 Bulletin 2025/43**

(21) Numéro de dépôt: **22830861.5**

(22) Date de dépôt: **07.12.2022**

(51) Classification Internationale des Brevets (IPC):
***H05B 6/42*** *(2006.01)*

(52) Classification Coopérative des Brevets (CPC):
**H05B 6/42**

(86) Numéro de dépôt international:
**PCT/EP2022/084844**

(87) Numéro de publication internationale:
**WO 2023/104911 (15.06.2023 Gazette 2023/24)**

(54) **ELEMENT D'UN EQUIPEMENT DE CHAUFFAGE PAR INDUCTION APTE A RECEVOIR UN FLUIDE DE REFROIDISSEMENT**

ELEMENT EINER INDUKTIONSHEIZVORRICHTUNG ZUR AUFNAHME EINES KÜHLMITTELS

ELEMENT OF AN INDUCTION HEATING APPARATUS SUITABLE FOR RECEIVING A COOLANT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **07.12.2021 FR 2113050**

(43) Date de publication de la demande:
**16.10.2024 Bulletin 2024/42**

(73) Titulaire: **Fives Celes**
**68610 Lautenbach (FR)**

(72) Inventeurs:
• **KEZER, Tony**
**68610 LAUTENBACH (FR)**
• **RAVERDY, Frédéric**
**68520 BURNHAUPT-LE-HAUT (FR)**

(74) Mandataire: **Novagraaf Group**
**Chemin de l'Echo 3**
**1213 Onex / Geneva (CH)**

(56) Documents cités:
**EP-B1- 2 027 754     US-A- 3 766 353**
**US-A1- 2003 047 558**

## Description

### Désignation du domaine technique concerné

L'invention est relative aux équipements de chauffage par induction et plus particulièrement à des éléments d'un circuit oscillant et à des éléments placés dans le champ magnétique généré par le circuit oscillant et dans lequel circule un courant induit par ledit champ magnétique.

### Problèmes techniques auxquels répond l'invention et arrière-plan technique

Les équipements de chauffage par induction comprennent des éléments en matériau conducteur d'électricité, typiquement des tôles en cuivre d'une épaisseur généralement comprise entre 0.5 et 5 mm, permettant la circulation de courants électriques. Ces tôles sont notamment utilisées pour former des inducteurs, des plaques d'alimentation entre une source de puissance et un inducteur, des blindages magnétiques autour d'un inducteur, des spires ou plaques de court-circuit à des extrémités d'un inducteur ou des tires chaleur. Les densités de courant étant souvent très élevées, ces éléments doivent être refroidis par un fluide afin de maintenir une température acceptable maximale d'environ 80 °C. Le moyen de refroidissement habituel de ces éléments fait appel au brasage sur la tôle en cuivre d'une pluralité de tubes de cuivre formant un serpentin, typiquement des tubes de diamètre 16 mm. Cela implique l'assemblage d'une grande quantité de pièces d'où une fiabilité diminuée avec des risques de fuite ou de mauvais contact mécanique et thermique entre le tube et la tôle réduisant la capacité à évacuer les calories. US 2003/047558 Al divulgue un élément selon le préambule de la revendication 1.

L'invention apporte une solution à ces problèmes avec des éléments permettant de limiter le nombre de pièces à assembler, tout en optimisant l'évacuation des calories grâce à une répartition du fluide de refroidissement plus homogène. L'invention permet ainsi d'optimiser le dimensionnement des systèmes de refroidissement et de limiter la présence de points chauds sur des éléments d'un équipement de chauffage par induction.

### Résumé de l'invention

Selon un premier aspect de l'invention, il est proposé un élément apte à être un composant d'un équipement de chauffage par induction, en particulier un élément d'un circuit oscillant pour la formation d'un champ électromagnétique destiné au chauffage d'un produit par induction, caractérisé en ce qu'il comprend une première tôle et une seconde tôle, les deux tôles étant en cuivre ou en alliage de cuivre, la première tôle recouvrant au moins partiellement une première grande face de la seconde tôle, les deux tôles étant reliées par une soudure continue périphérique formant un contour, à l'intérieur duquel les tôles sont principalement distantes et forment entre elles un volume prévu pour recevoir une circulation d'un fluide de refroidissement et en ce que la résistance mécanique à la déformation plastique de la première tôle est plus faible de que celle de la seconde tôle dans une proportion telle qu'une mise en pression du volume entre les deux tôles peut entrainer une déformation plastique de la première tôle sans déformer plastiquement la seconde tôle.

L'élément selon l'invention forme un ensemble rigide et robuste apte à recevoir un fluide de refroidissement entre les deux tôles à l'intérieur du contour formé par la soudure continue périphérique. Cet élément est plus simple et moins couteux à fabriquer que selon l'état de la technique. Il présente également moins de risque de fuite du fluide de refroidissement, pour un refroidissement plus distribué et plus efficace.

L'élément est apte à être traversé par un courant électrique alternatif, quelle que soit sa fréquence, par exemple 80 kHz, sans échauffement excessif du fait de l'évacuation des calories produites par effet Joule par le fluide de refroidissement circulant entre les tôles.

Selon une variante de réalisation de l'invention, l'élément comprend une troisième tôle dont la résistance mécanique à la déformation plastique est inférieure à celle de la seconde tôle, la troisième tôle étant disposée sur la seconde grande face de la seconde tôle, la troisième tôle et la seconde tôle étant reliées par une soudure continue périphérique définissant un contour à l'intérieur duquel la troisième tôle et la seconde tôle sont principalement distantes et forment entre elles un volume dans lequel peut circuler un fluide de refroidissement.

Cette configuration permet d'augmenter la capacité de refroidissement de l'élément, par exemple de la doubler.

Lorsque l'élément est un composant d'un circuit oscillant, il est traversé par un important courant électrique dont l'intensité est fonction de la puissance à délivrer. Plus la fréquence de ce courant est élevée et plus le courant électrique circule et se concentre à la surface des grandes faces opposées de la seconde tôle plus épaisse. Cela conduit à un échauffement plus important des deux grandes faces opposées de la tôle et à un moindre échauffement au centre de l'épaisseur de la tôle. Il est ainsi avantageux de disposer d'un élément disposant d'un refroidissement par les deux grandes faces opposées de la tôle plus épaisse, ou ayant la plus grande résistance mécanique.

Selon un exemple de réalisation de l'invention, la résistance mécanique à la déformation plastique plus faible de la première tôle et/ou de la troisième tôle résulte d'une moindre épaisseur de la première tôle, et/ou de la troisième tôle, par rapport à la seconde tôle.

Pour un même état métallurgique des tôles, une différence d'épaisseur de la première et la troisième tôle avec la seconde tôle est choisie de sorte que seules la première et la troisième tôle se déforment plastiquement sous l'effet de la pression du fluide injecté dans l'élément jusqu'à atteindre la forme souhaitée. Ainsi, la forme principale de l'élément est conservée malgré la déformation des tôles plus fines du fait de la non-déformation de la tôle plus épaisse.

La profondeur de pénétration ε du courant électrique dans les tôles de l'élément dépend de la fréquence du courant à laquelle fonctionne le circuit oscillant. Cette profondeur diminue lorsque la fréquence augmente selon la formule ci-dessous dans laquelle f est la fréquence du courant du circuit oscillant, μ est la perméabilité magnétique relative de la tôle et σ est sa conductivité électrique :

$$\varepsilon = \frac{1}{\sqrt{\pi.f.\mu.\sigma}}$$

Les épaisseurs des tôles sont choisies de sorte que le courant électrique passe préférentiellement dans la tôle plus épaisse. La circulation du courant étant fonction de sa fréquence, la quantité de courant circulant dans la tôle la plus fine sera d'autant plus faible que son épaisseur sera limitée et que la fréquence sera élevée. En dessous d'une certaine fréquence, pour une épaisseur donnée, le courant ne circulera pas dans cette tôle plus fine, ou très peu.

La première et la troisième tôle peuvent être de même épaisseur ou d'épaisseur différente. Avantageusement, les deux tôles disposées de part et d'autre de la seconde tôle la plus épaisse sont de même épaisseur. L'utilisation de tôles de même épaisseur facilite les opérations de soudure puisqu'un même réglage des conditions de soudure peut être utilisé pour la soudure des deux tôles plus fines. De plus, dans le cas où les deux tôles sont soudées simultanément sur la tôle plus épaisse par une même soudure, l'utilisation de tôles de même épaisseur permet d'obtenir un même résultat sur les deux tôles ce qui pourrait ne pas être le cas si les deux tôles étaient d'épaisseurs différentes.

Selon un autre exemple de réalisation de l'invention, la résistance mécanique à la déformation plastique plus faible de la première tôle et/ou de la troisième tôle résulte d'un état métallurgique différent de la première tôle, et/ou de la troisième tôle, par rapport à la seconde tôle, la première tôle et/ou la troisième étant par exemple dans un état recuit et la seconde tôle dans un état écroui.

La différence d'état métallurgique de la première et la troisième tôle avec la seconde tôle est choisie de sorte que seules la première et la troisième tôle se déforment plastiquement sous l'effet de la pression du fluide injecté dans l'élément jusqu'à atteindre la forme souhaitée. Ainsi, la forme principale de l'élément est conservée malgré la déformation des tôles moins résistantes du fait de la non-déformation de la tôle plus résistante. La première et la troisième tôle peuvent avoir la même résistance mécanique à la déformation plastique ou des résistances différentes.

Selon un autre exemple de réalisation de l'invention, la résistance mécanique à la déformation plastique plus faible de la première tôle et/ou de la troisième tôle résulte de la combinaison d'une moindre épaisseur et d'un état métallurgique différent de la première tôle, et/ou de la troisième tôle, par rapport à la seconde tôle.

L'épaisseur et l'état métallurgique de la première et la troisième tôle comparés à ceux de la seconde tôle sont choisis de sorte que seules la première et la troisième tôle se déforment plastiquement sous l'effet de la pression du fluide injecté dans l'élément jusqu'à atteindre la forme souhaitée. Ainsi, la forme principale de l'élément est conservée malgré la déformation des tôles plus fines du fait de la non-déformation de la tôle plus épaisse. La première et la troisième tôle peuvent être d'une épaisseur différente. Par exemple, la première tôle peut être plus épaisse que la troisième tôle mais avoir un état métallurgique offrant moins de résistance mécanique à la déformation que celui de la troisième tôle.

Une tôle dont l'état métallurgique est écroui à une résistance mécanique plus élevée qu'une tôle recuite. Le niveau de résistance sera d'autant plus élevé que le niveau d'écrouissage sera plus important. Pour faciliter la déformation plastique d'une tôle écrouie, on lui fait subir un recuit de recristallisation en la portant à une température élevée, par exemple de 300 à 600 °C, pendant une durée suffisante, par exemple entre 15 minutes et 6 heures. Le niveau de résistance mécanique d'une tôle recuite sera lié à l'importance du recuit, selon qu'il est complet ou partiel, c'est-à-dire selon la température de celui-ci et le temps de maintien à cette température.

Avantageusement selon l'invention, à l'intérieur du contour formé par la soudure continue périphérique, la première tôle et la seconde tôle et/ou la troisième tôle et la seconde tôle sont reliées par une pluralité de soudures continues et/ou discontinues.

Avec un volume homogène ouvert entre les deux tôles du fait de la seule présence de la soudure continue périphérique, l'écoulement du liquide de refroidissement n'est pas canalisé entre les deux tôles et la dissipation thermique n'est pas optimale du fait de turbulences limitées. L'ajout, selon l'invention, d'une pluralité de soudures continues ou discontinues à l'intérieur du contour formé par la soudure continue périphérique a pour effet de former des canaux dans lesquels s'écoule le fluide de refroidissement, permettant ainsi de canaliser et de distribuer le fluide de refroidissement sur toute la surface de l'élément tout en créant des turbulences hydrauliques permettant d'augmenter le coefficient d'échange et de tirer plus de calories. La pluralité de soudures continues ou discontinues améliore ainsi l'efficacité et la distribution du refroidissement à l'intérieur du contour formé par la soudure continue périphérique. Ces soudures sont avantageusement discontinues de sorte qu'il n'y ait pas de surface de la tôle plus résistante qui ne soit pas accessible au fluide de refroidissement à l'intérieur du contour formé par la soudure continue périphérique, ou de limiter cette surface non accessible au fluide de refroidissement.

La pluralité de soudures continues ou discontinues située à l'intérieur de la soudure continue périphérique permet également de contenir la déformation de la tôle moins résistante. Elle donne plus de rigidité à la tôle déformée et une meilleure tenue mécanique à l'élément. Il a ainsi une meilleure résistance mécanique à la déformation en cas de choc mécanique.

Avantageusement, les trois tôles sont reliées par une même soudure continue périphérique et de mêmes soudures continues et/ou discontinues à l'intérieur du contour formé par la soudure continue périphérique.

Une soudure continue est par exemple réalisée par deux molettes en rotation sur les faces extérieures des tôles fines, disposées en vis-à-vis de part et d'autre de l'élément et alimentées en courant. Le courant circulant entre les molettes entraine une fusion et la soudure des tôles. Chaque soudure discontinue est par exemple une soudure par point, obtenue par exemple par deux molettes telles que décrites précédemment ou par deux électrodes. Les soudures peuvent également, par exemple, être réalisées par soudage laser ou par malaxage. Elles peuvent également être réalisées par collage. A noter qu'en cas de collage, le terme de soudure utilisé ici n'est pas tout à fait approprié.

Relier les trois tôles par une même soudure permet de limiter le nombre de soudures nécessaires à la réalisation de l'élément, réduisant ainsi la durée et le coût de sa fabrication. Cela permet également de disposer d'un élément symétrique selon le plan passant par le milieu de la tôle centrale d'où un refroidissement symétrique sur ses deux grandes faces.

Avantageusement, l'élément est de forme plane ou de forme courbée ou d'une forme combinant une ou plusieurs parties planes et une ou plusieurs parties courbées.

L'invention peut facilement être mise en œuvre pour une grande variété de formes de l'élément, permettant ainsi de s'adapter au besoin, par exemple, à la fonction et à la position de l'élément dans l'équipement de chauffage par induction ou à la géométrie de la pièce à chauffer par induction.

Selon un second aspect de l'invention, il est proposé un inducteur pour le chauffage d'un produit par induction, l'inducteur comprenant une paroi disposée en vis-à-vis du produit à chauffer reliée à une plaque d'alimentation raccordée à une source de courant alternatif, dans lequel la paroi de l'inducteur, et/ou la plaque d'alimentation, comprend un élément selon le premier aspect de l'invention.

L'inducteur peut être formé d'un seul élément ou d'un assemblage d'éléments selon l'invention. L'assemblage d'éléments peut être avantageux pour les inducteurs de grandes dimensions ou de formes complexes. Les éléments peuvent être tous identiques ou ils peuvent être différents pour s'adapter au mieux aux caractéristiques de l'inducteur.

Les deux plaques d'alimentation d'un inducteur sont souvent identiques. Chacune est avantageusement formée d'un seul élément selon l'invention.

Lorsqu'une paroi de l'inducteur comprend un élément selon l'invention avec seulement deux tôles, la première tôle moins épaisse et la seconde tôle plus épaisse, l'élément formant tout ou partie de la paroi disposée en vis-à-vis du produit à chauffer a sa seconde tôle plus épaisse disposée vers l'intérieur de l'inducteur.

En prenant le chemin le moins résistif, le courant électrique circulant dans l'inducteur va passer préférentiellement dans la tôle la plus épaisse de l'élément. C'est ainsi celle-ci qui produit l'essentiel du champ électromagnétique qui va chauffer le produit par induction. En plaçant la tôle plus fine de l'élément sur la face extérieure de l'inducteur, celle-ci n'interfère pas sur le champ magnétique produit par la tôle épaisse vers le produit à chauffer.

Selon un troisième aspect de l'invention, il est proposé un équipement de chauffage par induction comprenant un inducteur selon le deuxième aspect de l'invention et un blindage magnétique autour de l'inducteur, dans lequel ledit blindage magnétique comprend un élément selon le premier aspect de l'invention.

Un blindage magnétique autour de l'inducteur évite que le champ magnétique ne vienne chauffer des pièces métalliques disposées dans le voisinage de l'inducteur, notamment la charpente qui supporte l'équipement de chauffe. Selon l'invention, dans le cas où l'élément du blindage magnétique est composé de tôles d'épaisseurs différentes, la tôle la plus épaisse de l'élément est placée en vis-à-vis de la source du champ magnétique, c'est-à-dire vers le produit à chauffer, afin de favoriser la circulation du champ magnétique dans la tôle la plus épaisse.

Une spire ou une plaque de court-circuit a pour fonction de canaliser le champ magnétique au plus près de l'inducteur. Comme le blindage magnétique, elle évite ainsi que le champ magnétique ne s'étende sur un volume plus important et ne vienne chauffer des pièces métalliques disposées dans le voisinage de l'inducteur. On trouve généralement deux spires ou plaques de court-circuit, une à chaque extrémité de l'inducteur selon une première direction. Les spires ou plaques de court-circuit étant placées dans le champ magnétique généré par l'inducteur, des courants électriques sont induits dans les spires ou plaques ce qui nécessite de les refroidir. Les spires ou plaques de court-circuit selon l'état de la technique sont formées par des tôles en cuivres sur lesquelles sont soudés des tubes en cuivres dans lesquels circule un fluide de refroidissement.

L'équipement de chauffage par induction selon l'invention peut comprendre un inducteur ayant au moins une spire ou plaque de court-circuit dans lequel ladite spire ou plaque de court-circuit comprend un élément selon le premier aspect de l'invention. Pour les mêmes raisons que pour l'inducteur, il est ainsi avantageux de former les spires ou plaques de court-circuit avec des éléments selon l'invention.

L'équipement de chauffage par induction selon l'invention peut comprendre un tire chaleur. Comme son nom l'indique, un tire chaleur a pour fonction d'évacuer des calories. C'est ainsi une pièce qui nécessite un refroidissement. Il en existe plusieurs modèles selon l'endroit où il est positionné, par exemple au niveau de culasses magnétiques. Selon l'état de la technique, un tire chaleur comprend une pièce en cuivre destinée à tirer les calories du dispositif à refroidir sur laquelle est soudé un tube en cuivre dans lequel circule le fluide de refroidissement. Pour les mêmes raisons que pour l'inducteur, il est avantageux de former les tires chaleur avec des éléments selon l'invention. Ainsi, l'équipement de chauffage par induction selon l'invention peut comprendre un tire chaleur, dans lequel ledit tire chaleur comprend un élément selon l'invention.

Selon un quatrième aspect de l'invention, il est proposé un procédé de fabrication d'un élément selon le premier aspect de l'invention, dans lequel le volume formé entre la première, et/ou la troisième tôle, et la seconde tôle est obtenu par une déformation plastique de la première tôle, et/ou de la troisième tôle qui résulte de l'injection d'un fluide sous pression entre les deux tôles à l'intérieur du contour formé par la soudure continue périphérique.

L'injection d'un fluide sous pression entre deux tôles a pour effet de déformer la tôle la moins résistante mécanique à une déformation plastique, par exemple car elle est plus fine ou du fait de son état métallurgique.

L'injection d'un fluide sous pression présente l'avantage de distribuer la pression exercée par le fluide à l'intérieur du contour formé par la soudure continue périphérique. Ainsi, les canaux de distribution du fluide de refroidissement formés par la déformation de la tôle peuvent facilement être de mêmes dimensions sur toute la surface, selon la distribution des soudures à l'intérieur du contour formé par la soudure continue périphérique. Il est également possible de modifier simplement les dimensions des canaux de distribution sur la surface de l'élément, par exemple pour renforcer le refroidissement dans une zone particulière de celui-ci, en ayant une distribution différente de soudures continues ou discontinues dans cette zone.

A noter que sans les soudures continues ou discontinues à l'intérieur du contour formé par la soudure continue périphérique, la déformation de la tôle plus fine obtenue par un fluide sous pression aurait pour effet d'éloigner davantage les deux tôles au centre du contour formé par la soudure continue périphérique. L'encombrement en épaisseur de l'élément en serait augmenté, ce qui peut être un inconvénient pour les configurations où une forte compacité est requise. De plus, la rigidité et la résistance mécanique à la déformation plastique de l'élément en cas de choc mécanique seraient plus faibles.

Selon son épaisseur, l'état métallurgique initial de la première ou de la troisième tôle peut ne pas être adapté pour que la tôle puisse être déformée avec le niveau de pression souhaité du fluide injecté pour obtenir la déformation. Selon l'invention, un recuit de la première, et/ou de la troisième tôle, est réalisé sur au moins la partie de la tôle située, ou destinée à être située, à l'intérieur du contour formé par la soudure continue périphérique devant se déformer plastiquement par l'injection d'un fluide sous pression.

Ce recuit permet de réduire la résistance mécanique de la tôle à un niveau permettant sa déformation. Le recuit peut être réalisé sur l'ensemble de la tôle avant qu'elle ne soit soudée sur la seconde tôle.

Le recuit peut également être réalisée uniquement sur la partie devant se déformer plastiquement. Ce recuit localisé peut être effectué avant que la tôle ne soit soudée sur la seconde tôle, ou après la réalisation de la soudure continue périphérique.

Selon une variante de réalisation de l'invention, le recuit est effectué après la réalisation de la soudure continue périphérique, le chauffage de la tôle à la température de recuit étant réalisé par le moyen utilisé pour réaliser la soudure continue périphérique et/ou une soudure continue ou discontinue à l'intérieur du contour formé par la soudure continue périphérique, ou par tout autre moyen.

Lorsque le moyen de soudage est adapté, par exemple celui utilisé pour une soudure laser, il peut être avantageux de réaliser l'apport de chaleur nécessaire au recuit avec le moyen de soudage, directement sur la surface de la tôle devant être déformée. Le moyen de soudage peut également permettre de chauffer la surface de la tôle afin d'abaisser davantage la résistance mécanique d'une tôle déjà recuite, ou partiellement recuite, pour en favoriser la déformation.

**Brève description des figures**

D'autres caractéristiques et avantages de l'invention apparaîtront au cours de la lecture de la description détaillée qui va suivre pour la compréhension de laquelle on se reportera aux dessins annexés dans lesquels :

[Fig.1] est une vue frontale schématique d'un élément selon un premier exemple de réalisation de l'invention ;
[Fig.2] est une vue frontale schématique d'un élément selon un second exemple de réalisation de l'invention ;
[Fig.3] est une vue frontale schématique d'un élément selon un troisième exemple de réalisation de l'invention ;
[Fig.4] est une vue frontale schématique d'un élément selon un quatrième exemple de réalisation de l'invention ;

[Fig.5] est une vue latérale schématique en coupe de l'élément de la [Fig.1] ;

[Fig.6] est une vue latérale schématique en coupe d'un élément selon une variante de réalisation de l'invention ;

[Fig.7] est une vue schématique en coupe d'un exemple d'équipement de chauffage par induction d'un produit plat selon un exemple de réalisation de l'invention ;

[Fig.8] est une vue schématique en coupe d'un exemple d'équipement de chauffage par induction d'un produit cylindrique selon un exemple de réalisation de l'invention ;

[Fig.9] est une vue frontale d'un inducteur pour le chauffage d'un produit plat comprenant des spires de court-circuit selon un exemple de réalisation de l'invention ;

[Fig.10] est une vue frontale d'un inducteur pour le chauffage d'un produit plat comprenant des plaques de court-circuit selon un exemple de réalisation de l'invention, et ;

[Fig.11] est une vue frontale d'un tire chaleur selon un exemple de réalisation de l'invention.

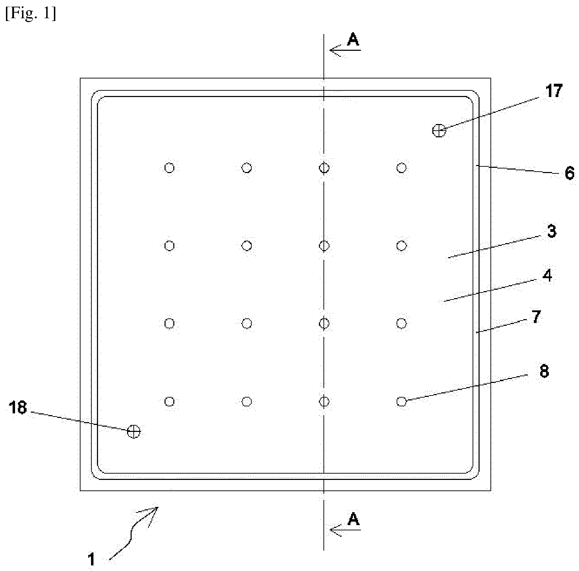

En se reportant au schéma de la [Fig.1], on peut voir une vue frontale schématique d'un élément selon un premier exemple de réalisation de l'invention. Il est formé de tôles 3, 4 superposées de sorte qu'une seule tôle est visible sur cette figure. Elles sont reliées par une soudure 6 continue réalisée sur leur périphérie de sorte de maximiser la surface à l'intérieur du contour 7 formé par la soudure continue. A l'intérieur de ce contour, des soudures discontinues 8 reliant les deux tôles 3, 4 sont présentes selon un maillage régulier. Les soudures discontinues sont ici des soudures par point. Deux conduits, l'un 17 d'alimentation et l'autre 18 d'évacuation, permettent la circulation d'un fluide de refroidissement entre les deux tôles. Ces conduits peuvent être situés sur la même tôle, comme représenté sur la [Fig.1], ou être disposés sur des tôles différentes.

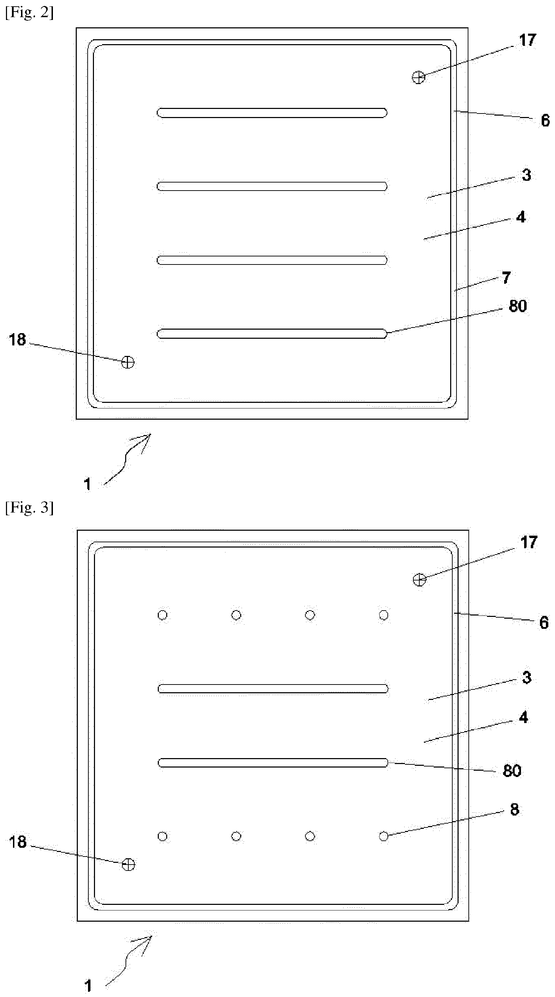

En se reportant au schéma de la [Fig.2], on peut voir une vue frontale schématique d'un élément selon un second exemple de réalisation de l'invention. Il se distingue du premier exemple par des soudures 80 discontinues linéaires.

En se reportant au schéma de la [Fig.3], on peut voir une vue frontale schématique d'un élément selon un troisième exemple de réalisation de l'invention dans lequel on combine des soudures discontinues 80 linéaires et des soudures discontinues 8 par points.

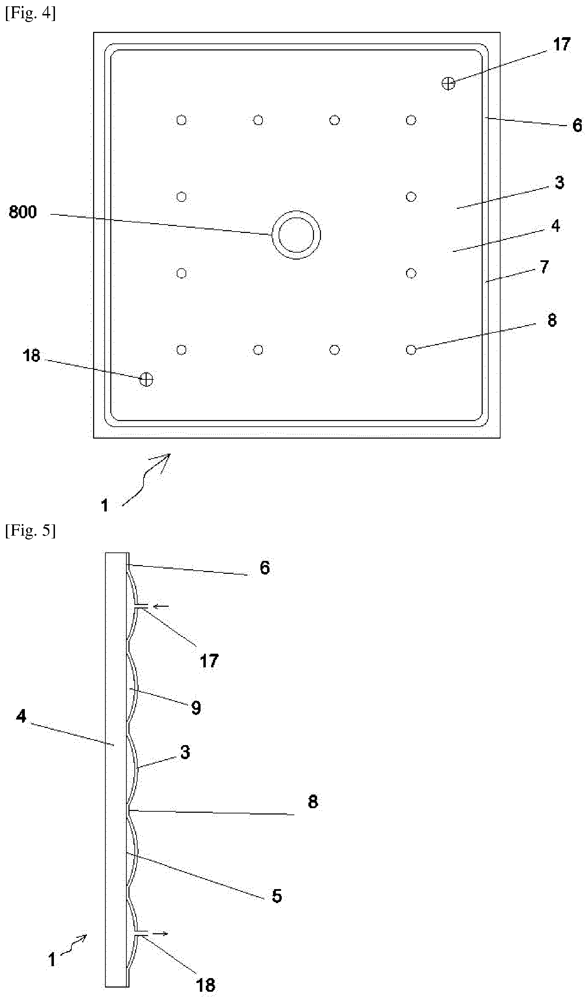

En se reportant au schéma de la [Fig.4], on peut voir une vue frontale schématique d'un élément selon un quatrième exemple de réalisation de l'invention dans lequel, à l'intérieur de la soudure 6 continue périphérique, on combine des soudures discontinues 8 par points et une soudure continue 800. La soudure continue 800 peut, par exemple, avoir comme fonction d'assurer un renforcement mécanique à l'endroit de l'élément où elle est réalisée. Selon un autre exemple, elle peut avoir pour fonction d'éviter la présence du fluide de refroidissement à l'intérieur de la surface qu'elle délimite.

La nature et la position des soudures continues et/ou discontinues disposées à l'intérieur du contour 7 formé par la soudure continue périphérique influent sur l'écoulement du fluide de refroidissement et sur la tenue mécanique de l'élément. Selon la fonction de l'élément et sa localisation dans l'inducteur ou l'équipement de chauffage, on peut choisir la nature et la position des soudures continues et/ou discontinues à l'intérieur du contour formé par la soudure continue périphérique.

En se reportant au schéma de la [Fig.5], on peut voir une vue latérale schématique en coupe de l'élément de la [Fig.1], selon le plan de coupe AA passant par des soudures discontinues visibles sur la [Fig.1]. La première tôle 3 de moindre épaisseur est disposée du côté d'une grande face 5 de la tôle 4 plus épaisse. Entre les soudures, la tôle 3 a été éloignée de cette face 5 pour créer un volume 9 entre les deux tôles par l'injection d'un fluide entre les deux tôles dont la pression a été choisie notamment selon leur résistance mécanique à la déformation ainsi que le niveau de déformation souhaité pour la tôle la plus fine.

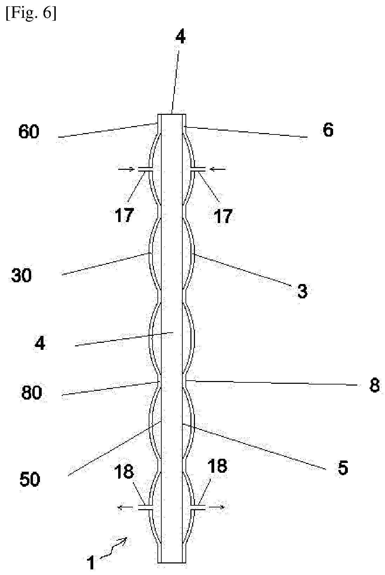

En se reportant au schéma de la [Fig.6], on peut voir une vue latérale schématique en coupe d'un élément similaire à la [Fig.5], mais selon une variante de réalisation de l'invention dans laquelle l'élément comprend deux tôles plus fines 3, 30, une de chaque côté 5, 50 de la tôle 4 plus épaisse. Dans cet exemple, les deux tôles plus fines sont de même épaisseur. Les deux tôles plus fines peuvent cependant être différentes, par exemple avec une épaisseur plus importante d'un côté de l'élément si une tenue mécanique plus importante est souhaitée de ce côté ou si la tôle de ce côté a une moindre résistance mécanique que celle située de l'autre côté de la tôle 4 la plus épaisse.

Dans cet exemple illustré en [Fig.6], les soudures continues 6, 60 et discontinues 8, 80 sont placées en vis-à-vis. Cela peut par exemple permettre de réaliser une liaison des trois tôles en une seule soudure. Les soudures continues et/ou discontinues peuvent également être décalées entre les deux grandes faces de la tôle la plus épaisse. Par exemple, un décalage des soudures peut être réalisé de sorte que la tôle plus épaisse soit toujours en contact avec le fluide de refroidissement sur au moins l'une de ces faces sur sa hauteur et sa largeur.

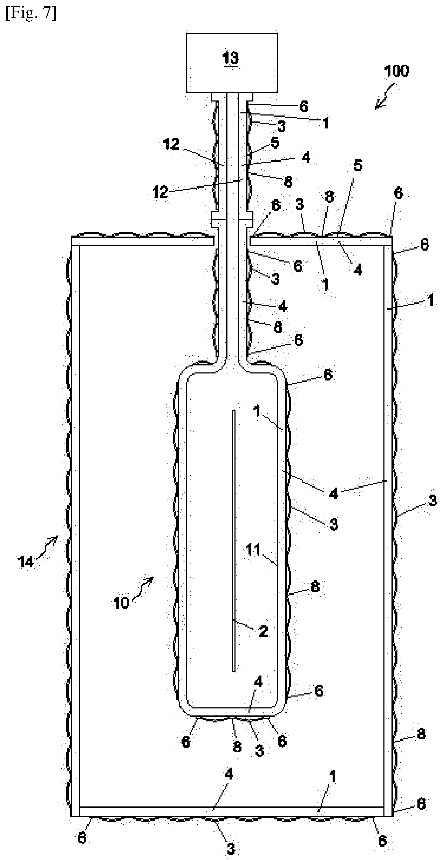

En se reportant au schéma de la [Fig.7], on peut voir une vue schématique en coupe d'un exemple d'équipement de chauffage par induction d'un produit 2 plat, ici une bande métallique. Il comprend un inducteur 10 raccordé à une source 13 de courant alternatif par deux plaques 12 d'alimentation, ainsi qu'un blindage 14 magnétique autour de l'inducteur. L'inducteur, les plaques d'alimentation et le blindage magnétique sont principalement formés d'éléments selon l'invention, dans sa variante avec une seule tôle plus fine.

Selon une variante, seul l'inducteur, et/ou la plaque d'alimentation, et/ou le blindage magnétique, ou deux des trois dispositifs pourraient être formés d'éléments selon l'invention.

Les éléments formant l'inducteur ont leur tôle plus fine disposée vers l'extérieur du centre de l'inducteur où se trouve le produit à chauffer. La tôle la plus épaisse est ainsi placée là où le courant aura tendance à circuler. Le courant passant préférentiellement dans la tôle la plus épaisse, le champ magnétique produit par l'inducteur est ainsi principalement généré par la tôle plus épaisse. Cette disposition rend le chauffage du produit plus efficace. De même, les éléments formant le blindage magnétique ont leur tôle plus fine disposée vers l'extérieur de l'équipement de chauffe afin de favoriser l'efficacité du blindage magnétique. En effet, le courant généré par le champ magnétique circulera du coté intérieur du blindage, donc sur la tôle plus épaisse. C'est également le cas pour les spires ou plaques de court-circuit.

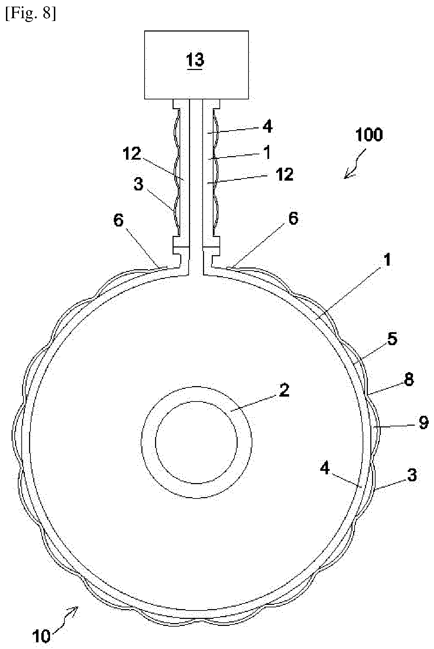

En se reportant au schéma de la [Fig.8], on peut voir une vue schématique en coupe d'un exemple d'équipement de chauffage par induction selon l'invention d'un produit 2 cylindrique. L'inducteur 10 peut avantageusement n'être formé que par un seul élément selon l'invention de forme cylindrique.

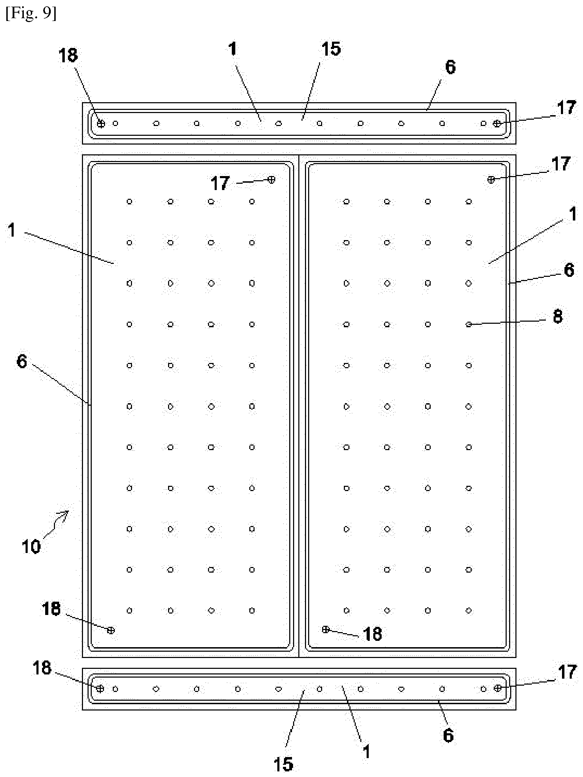

En se reportant au schéma de la [Fig.9], on peut voir une vue frontale d'un inducteur 10 avec ses deux spires 15 de court-circuit pour le chauffage d'un produit plat selon un exemple de réalisation de l'invention. Dans cet exemple, les grandes faces de l'inducteur sont formées par deux éléments selon l'invention et celles des spires de court-circuit par un seul.

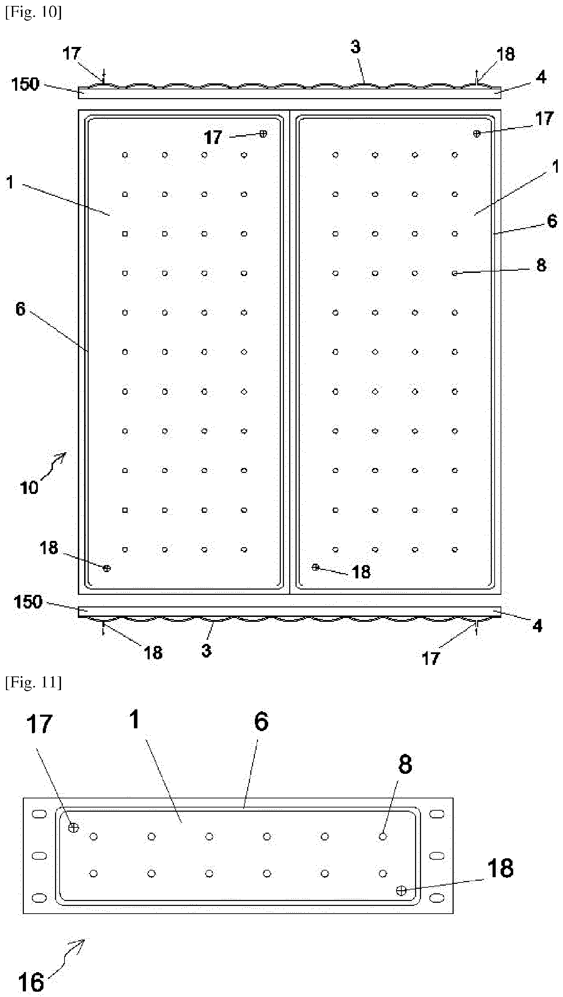

En se reportant au schéma de la [Fig.10], on peut voir une vue frontale d'un inducteur 10 similaire à celui de la [Fig.9], mais comprenant deux plaques 150 de court-circuit à la place de spires de court-circuit, selon un exemple de réalisation de l'invention.

L'inducteur a ainsi une apparence qui ressemble à celle d'un matelas capitonné, avec des formes bombées entre les soudures rappelant celles d'un matelas entre ses piqures.

En se reportant au schéma de la [Fig.11], on peut voir un exemple de tire chaleur 16 selon l'invention, en vue frontale, formé par un seul élément.

1 - Elément selon l'invention
2 - Produit chauffé par induction
3 - Première tôle de moindre épaisseur
30 - Troisième tôle de moindre épaisseur
4 - Seconde tôle plus épaisse
5 - Première grande face de la seconde tôle 4
50 - Seconde grande face de la seconde tôle 4
6 - Soudure continue
60 - Soudure continue
7 - Contour de la soudure continue
70 - Contour de la soudure continue
8 - Soudure discontinue
80 - Soudure discontinue

800 - Soudure continue disposée à l'intérieur du contour 7 formé par la soudure 6, 60 continue périphérique
9 - Volume entre les premières et secondes tôles
90 - Volume entre les secondes et troisièmes tôles
10 - Inducteur
11 - Paroi de l'inducteur disposée en vis-à-vis du produit 2
12 - Plaque d'alimentation d'un inducteur 10
13 - Source de courant alternatif
14 - Blindage magnétique
15 - Spire de court-circuit
150 - Plaque de court-circuit
16 - Tire chaleur
17 - Entrée du fluide de refroidissement
18 - Sortie du fluide de refroidissement
100 - Equipement de chauffage

**Revendications**

1. Elément apte à être un composant d'un équipement de chauffage par induction destiné au chauffage d'un produit (2) par induction, en particulier un élément pour un circuit oscillant pour la formation d'un champ électromagnétique, **caractérisé en ce qu'**il comprend une première tôle (3) et une seconde tôle (4), les deux tôles étant en cuivre ou en alliage de cuivre, la première tôle (3) recouvrant au moins partiellement une première grande face (5) de la seconde tôle (4), les deux tôles étant reliées par une soudure (6) continue périphérique formant un contour (7), à l'intérieur duquel les tôles (3, 4) sont principalement distantes et forment entre elles un volume (9) prévu pour recevoir une circulation d'un fluide de refroidissement et **en ce que** la résistance mécanique à la déformation plastique de la première tôle (3) est plus faible que celle de la seconde tôle (4) dans une proportion telle qu'une mise en pression du volume (9) entre les deux tôles (3, 4) peut entrainer une déformation plastique de la première tôle (3) sans déformer plastiquement la seconde tôle (4).

2. Elément selon la revendication 1, **caractérisé en ce qu'**il comprend une troisième tôle (30) dont la résistance mécanique à la déformation plastique est inférieure à celle de la seconde tôle (4), la troisième tôle étant disposée sur la seconde grande face (50) de la seconde tôle, la troisième tôle et la seconde tôle étant reliées par une soudure (60) continue périphérique définissant un contour (70) à l'intérieur duquel la troisième tôle (30) et la seconde tôle (4) sont principalement distantes et forment entre elles un volume (90) dans lequel peut circuler un fluide de refroidissement.

3. Elément selon l'une des revendications 1, **caractérisé en ce que** la résistance mécanique à la déformation plastique plus faible de la première tôle (3), et/ou de la troisième tôle (30) lorsque ledit élément dépend en outre de la revendication 2, résulte d'une moindre épaisseur de la première tôle, et/ou de la troisième tôle, par rapport à la seconde tôle (4).

4. Elément selon l'une des revendications 1, **caractérisé en ce que** la résistance mécanique à la déformation plastique plus faible de la première tôle (3), et/ou de la troisième tôle (30) lorsque ledit élément dépend en outre de la revendication 2, résulte d'un état métallurgique différent de la première tôle, et/ou de la troisième tôle, par rapport à la seconde tôle (4), la première tôle et/ou la troisième étant par exemple dans un état recuit et la seconde tôle dans un état écroui.

5. Elément selon la revendication 1, **caractérisé en ce que** la résistance mécanique à la déformation plastique plus faible de la première tôle (3), et/ou de la troisième tôle (30) lorsque ledit élément dépend en outre de la revendication 2, résulte de la combinaison d'une moindre épaisseur et d'un état métallurgique différent de la première tôle, et/ou de la troisième tôle, par rapport à la seconde tôle (4).

6. Elément selon l'une des revendications 1 ou 2, **caractérisé en ce qu'**à l'intérieur du contour (7) formé par la soudure (6, 60) continue périphérique, la première tôle (3) et la seconde tôle (4) et/ou, lorsque la revendication est dépendante de la revendication 2, la troisième tôle (30) et la seconde tôle (4) sont reliées par une pluralité de soudures (8, 80, 800) continues et/ou discontinues.

7. Elément selon la revendication 6, en combinaison avec la revendication 2, **caractérisé en ce que** les trois tôles (3, 30, 4) sont reliées par une même soudure (6, 60) continue périphérique et de mêmes soudures continues et/ou discontinues (8, 80, 800) à l'intérieur du contour (7) formé par la soudure (6, 60) continue périphérique.

8. Elément selon la revendication 2, **caractérisé en ce que** les deux tôles (3, 30) disposées de part et d'autre de la seconde tôle (4) la plus épaisse sont de même épaisseur.

9. Elément selon l'une des revendications précédentes, **caractérisé en ce qu'**il est de forme plane ou de forme courbée ou d'une forme combinant une ou plusieurs parties planes et une ou plusieurs parties courbées.

10. Inducteur (10) pour le chauffage d'un produit (2) par induction,
l'inducteur comprenant une paroi (11) disposée en vis-à-vis du produit à chauffer reliée à une plaque (12) d'alimentation raccordée à une source (13) de courant alternatif, **caractérisé en ce que** la paroi de l'inducteur, et/ou la plaque d'alimentation, comprend un élément selon l'une des revendications précédentes.

11. Inducteur selon la revendication précédente, comprenant un élément selon l'une des revendications 1 à 9 avec seulement deux tôles, la première tôle (3) étant moins épaisse que la seconde tôle (4), l'élément formant tout ou partie de la paroi (11) disposée en vis-à-vis du produit (2) à chauffer, **caractérisé en ce que** la seconde tôle (4) plus épaisse est disposée vers l'intérieur de l'inducteur où sera disposée le produit à chauffer.

12. Equipement (100) de chauffage par induction comprenant un inducteur selon l'une des deux revendications précédentes et un blindage (14) magnétique autour de l'inducteur, **caractérisé en ce que** ledit blindage magnétique comprend un élément selon l'une des revendications 1 à 9.

13. Equipement (100) de chauffage par induction selon la revendication précédente, dans lequel l'inducteur comprend une spire (15) ou une plaque (150) de court-circuit, **caractérisé en ce que** ladite spire ou plaque de court-circuit comprend un élément selon l'une des revendications 1 à 9.

14. Equipement (100) de chauffage par induction selon la revendication 12, comportant un tire chaleur (16), **caractérisé en ce que** ledit tire chaleur comprend un élément selon l'une des revendications 1 à 9.

15. Procédé de fabrication d'un élément selon l'une des revendications 1 à 9, **caractérisé en ce que** le volume (9, 90) formé entre la première (3), et/ ou la troisième (30) tôle lorsque ledit élément dépend en outre de la revendication 2, et la seconde tôle (4) est obtenu par une déformation plastique de la première tôle, et/ou de la troisième tôle qui résulte de l'injection d'un fluide sous pression entre les deux tôles à l'intérieur du contour formé par la soudure (6, 60) continue périphérique.

16. Procédé selon la revendication précédente, **caractérisé en ce qu'**un recuit de la première (3), et/ou de la troisième (30) tôle lorsque l'élément dépend en outre de la revendication 2, est réalisé sur au moins la partie de la tôle située, ou destinée à être située, à l'intérieur du contour formé par la soudure (6, 60) continue périphérique devant se déformer plastiquement par l'injection d'un fluide sous pression.

17. Procédé selon la revendication précédente, **caractérisé en ce que** le recuit est effectué après la réalisation de la soudure (6, 60) continue périphérique, le chauffage de la tôle à la température de recuit étant réalisé par le moyen utilisé pour réaliser la soudure (6, 60) continue périphérique et/ou une soudure (800) continue ou discontinue (8, 80) à l'intérieur du contour formé par la soudure (6, 60) continue périphérique, ou par un autre moyen de chauffe.

**Patentansprüche**

1. Element, das geeignet ist, um ein Bestandteil einer Induktionsheizeinrichtung zu sein, die dazu bestimmt ist, ein Produkt (2) durch Induktion zu erhitzen, insbesondere ein Element für einen Schwingkreis für die Ausbildung eines elektromagnetischen Feldes,
   **dadurch gekennzeichnet, dass** es ein erstes Blech (3) und ein zweites Blech (4) umfasst, wobei die zwei Bleche aus Kupfer oder aus einer Kupferlegierung sind, wobei das erste Blech (3) eine erste Hauptfläche (5) des zweiten Blechs (4) mindestens teilweise bedeckt, wobei die zwei Bleche durch eine umlaufende Schweißnaht (6) verbunden sind, die eine Kontur (7) ausbildet, innerhalb derer die Bleche (3, 4) größtenteils beabstandet sind und zwischen sich ein Volumen (9) ausbilden, das zum Aufnehmen einer Zirkulation eines Kühlfluids vorgesehen ist, und **dass** der mechanische Widerstand des ersten Blechs (3) gegenüber der plastischen Verformung geringer als der des zweiten Blechs (4) ist, in einem solchen Verhältnis, dass eine Druckbeaufschlagung des Volumens (9) zwischen den zwei Blechen (3, 4) eine plastische Verformung des ersten Blechs (3) bewirken kann, ohne das zweite Blech (4) plastisch zu verformen.

2. Element nach Anspruch 1, **dadurch gekennzeichnet, dass** es ein drittes Blech (30) umfasst, dessen mechanischer Widerstand gegenüber der plastischen Verformung geringer als der des zweiten Blechs (4) ist, wobei das dritte Blech auf der zweiten Hauptfläche (50) des zweiten Blechs angeordnet ist, wobei das dritte Blech und das zweite Blech durch eine umlaufende Schweißnaht (60) verbunden sind, die eine Kontur (70) definiert, innerhalb derer das dritte Blech (30) und das zweite Blech (4) größtenteils voneinander beabstandet sind und zwischen sich ein Volumen (90) ausbilden, in dem ein Kühlfluid zirkulieren kann.

3. Element nach einem der Ansprüche 1, **dadurch gekennzeichnet, dass** der geringere mechanische Widerstand gegenüber der plastischen Verformung des ersten Blechs (3) und/oder des dritten Blechs (30), wenn das Element ferner von Anspruch 2 abhängt, aus einer geringeren Dicke des ersten Blechs und/oder des dritten Blechs im Vergleich zu dem zweiten Blech (4) resultiert.

4. Element nach einem der Ansprüche 1, **dadurch gekennzeichnet, dass** der geringere mechanische Widerstand gegenüber der plastischen Verformung des ersten Blechs (3) und/oder des dritten Blechs (30), wenn das Element ferner von Anspruch 2 abhängt, aus einem unterschiedlichen metallurgischen Zustand des ersten Blechs und/oder des dritten Blechs im Vergleich zu dem zweiten Blech (4) resultiert, wobei sich das erste Blech und/oder das dritte Blech beispielsweise in einem geglühten Zustand und das zweite Blech in einem kaltverfestigten Zustand befinden.

5. Element nach Anspruch 1, **dadurch gekennzeichnet, dass** der geringere mechanische Widerstand gegenüber der plastischen Verformung des ersten Blechs (3) und/oder des dritten Blechs (30), wenn das Element ferner von Anspruch 2 abhängt, aus der Kombination einer geringeren Dicke und eines anderen metallurgischen Zustands des ersten Blechs und/oder des dritten Blechs im Vergleich zu dem zweiten Blech (4) resultiert.

6. Element nach einem der Ansprüche 1 oder 2, **dadurch gekennzeichnet, dass** innerhalb der Kontur (7), die durch die umlaufende Schweißnaht (6, 60) ausgebildet ist, das erste Blech (3) und das zweite Blech (4) und/oder, wenn der Anspruch von Anspruch 2 abhängt, das dritte Blech (30) und das zweite Blech (4) durch eine Vielzahl von Schweißnähten und/oder unterbrochenen Schweißungen (8, 80, 800) verbunden sind.

7. Element nach Anspruch 6 in Kombination mit Anspruch 2,
   **dadurch gekennzeichnet, dass** die drei Bleche (3, 30, 4) durch eine gleiche umlaufende Schweißnaht (6, 60) und die gleichen Schweißnähte und/oder unterbrochenen Schweißungen (8, 80, 800) innerhalb der Kontur (7) verbunden sind, die durch die umlaufende Schweißnaht (6, 60) ausgebildet ist.

8. Element nach Anspruch 2, **dadurch gekennzeichnet, dass** die zwei Bleche (3, 30), die auf beiden Seiten des zweitdicksten Blechs (4) angeordnet sind, eine gleiche Dicke aufweisen.

9. Element nach einem der vorstehenden Ansprüche, **dadurch gekennzeichnet, dass** es eine flache Form oder eine gebogene Form oder eine Form aufweist, die einen oder mehrere flache Teile und einen oder mehrere gebogene Teile kombiniert.

10. Induktor (10) für die Erhitzung eines Produkts (2) durch Induktion, der Induktor umfassend eine Wand (11), die gegenüber dem zu erhitzenden Produkt angeordnet ist, die mit einer Stromversorgungsplatte (12) verbunden ist, die wiederum an eine Wechselstromquelle (13) angeschlossen ist,
**dadurch gekennzeichnet, dass** die Wand des Induktors und/oder die Versorgungsplatte ein Element nach einem der vorstehenden Ansprüche aufweist.

**11.** Induktor nach dem vorstehenden Anspruch, umfassend ein Element nach einem der Ansprüche 1 bis 9 mit nur zwei Blechen, wobei das erste Blech (3) weniger dick als das zweite Blech (4) ist, das Element die gesamte oder einen Teil der Wand (11) ausbildet, die gegenüber dem zu erhitzenden Produkt (2) angeordnet ist,
**dadurch gekennzeichnet, dass** das zweite, dickere Blech (4) zu der Innenseite des Induktors hin angeordnet ist, wo das zu erhitzende Produkt angeordnet wird.

**12.** Induktionsheizeinrichtung (100), umfassend einen Induktor nach einem der zwei vorstehenden Ansprüche und eine magnetische Abschirmung (14) um den Induktor herum, **dadurch gekennzeichnet, dass** die magnetische Abschirmung ein Element nach einem der Ansprüche 1 bis 9 umfasst.

**13.** Induktionsheizeinrichtung (100) nach dem vorstehenden Anspruch, wobei der Induktor eine Kurzschlusswicklung (15) oder -platte (150) umfasst,
**dadurch gekennzeichnet, dass** die Kurzschlusswicklung oder -platte ein Element nach einem der Ansprüche 1 bis 9 umfasst.

**14.** Induktionsheizeinrichtung (100) nach Anspruch 12, die einen Hitzeabzug (16) vorweist, **dadurch gekennzeichnet, dass** der Hitzeabzug ein Element nach einem der Ansprüche 1 bis 9 umfasst.

**15.** Verfahren zum Herstellen eines Elements nach einem der Ansprüche 1 bis 9, **dadurch gekennzeichnet, dass** das Volumen (9, 90), das zwischen dem ersten (3) und/oder dem dritten (30) Blech, wenn das Element ferner von Anspruch 2 abhängt, und dem zweiten Blech (4) ausgebildet ist, durch eine plastische Verformung des ersten Blechs und/oder des dritten Blechs erhalten wird, die aus der Injektion eines unter Druck stehenden Fluids zwischen die zwei Bleche innerhalb der Kontur resultiert, die durch die umlaufende Schweißnaht (6, 60) ausgebildet ist.

**16.** Verfahren nach dem vorstehenden Anspruch,
**dadurch gekennzeichnet, dass** ein Glühen des ersten (3) und/oder des dritten (30) Blechs, wenn das Element ferner von Anspruch 2 abhängt, an mindestens dem Teil des Blechs durchgeführt wird, der sich innerhalb der Kontur, die durch die umlaufende Schweißnaht (6, 60) ausgebildet ist, befindet oder dazu bestimmt ist, sich darin zu befinden, die sich durch die Injektion eines unter Druck stehenden Fluids plastisch verformen muss.

**17.** Verfahren nach dem vorstehenden Anspruch,
**dadurch gekennzeichnet, dass** das Glühen nach der Herstellung der umlaufenden Schweißnaht (6, 60) erfolgt, wobei die Erhitzung des Blechs auf die Glühtemperatur durch das Mittel, das zum Herstellen der umlaufenden Schweißnaht (6, 60) und/oder einer Schweißnaht (800) oder unterbrochenen Schweißung (8, 80) innerhalb der Kontur verwendet werden, die durch die umlaufende Schweißnaht (6, 60) ausgebildet ist, oder durch ein anderes Heizmittel erfolgt.

## Claims

**1.** Element suitable for use as a component of an induction heating apparatus for inductively heating a product (2), in particular an element for an oscillating circuit for forming an electromagnetic field,
**characterized in that** it comprises a first metal sheet (3) and a second metal sheet (4), the two metal sheets being made of copper or a copper alloy, the first metal sheet (3) at least partially covering a first large face (5) of the second metal sheet (4), the two metal sheets being connected by a continuous peripheral weld (6) forming a contour (7), within which the metal sheets (3, 4) are mainly spaced apart and form between them a volume (9) designed to receive a circulation of a cooling fluid **and in that** the mechanical resistance to plastic deformation of the first metal sheet (3) is lower than that of the second metal sheet (4) in such a proportion that pressurization of the volume (9) between the two metal sheets (3, 4) can cause plastic deformation of the first metal sheet (3) without plastically deforming the second metal sheet (4).

**2.** Element according to claim 1, **characterized in that** it comprises a third metal sheet (30) of which the mechanical resistance to plastic deformation is lower than that of the second metal sheet (4), the third metal sheet being arranged on the second large face (50) of the second metal sheet, the third metal sheet and the second metal sheet being connected by a continuous peripheral weld (60) defining a contour (70) within which the third metal sheet (30) and the second metal sheet (4) are mainly spaced apart and form between them a volume (90) in which a cooling fluid can circulate.

**3.** Element according to one of claims 1, **characterized in that** the lower mechanical resistance to plastic deformation of the first metal sheet (3), and/or of the third metal sheet (30) when said element further depends on claim 2, results from a lower thickness of the first metal sheet, and/or of the third metal sheet, compared to the second metal sheet (4).

**4.** Element according to one of claims 1, **characterized in that** the lower mechanical resistance to plastic deformation of the first metal sheet (3), and/or of the third metal sheet (30) when said element further depends on claim 2, results from a different metallurgical state of the first metal sheet, and/or of the third metal sheet, compared to the second metal sheet (4), the first metal sheet and/or the third metal sheet being for example in an annealed state and the second metal sheet in a work-hardened state.

**5.** Element according to claim 1, **characterized in that** the lower mechanical resistance to plastic deformation of the first metal sheet (3), and/or of the third metal sheet (30) when said element further depends on claim 2, results from the combination of a lower thickness and a different metallurgical state of the first metal sheet, and/or of the third metal sheet, compared to the second metal sheet (4).

**6.** Element according to one of claims 1 or 2, **characterized in that** within the contour (7) formed by the peripheral continuous weld (6, 60), the first metal sheet (3) and the second metal sheet (4) and/or, when the claim is dependent on claim 2, the third metal sheet (30) and the second metal sheet (4) are connected by a plurality of continuous and/or discontinuous welds (8, 80, 800).

**7.** Element according to claim 6, in combination with claim 2,
**characterized in that** the three metal sheets (3, 30, 4) are connected by the same peripheral continuous weld (6, 60) and the same continuous and/or discontinuous welds (8, 80, 800) within the contour (7) formed by the peripheral continuous weld (6, 60).

**8.** Element according to claim 2, **characterized in that** the two metal sheets (3, 30) arranged on either side of the second, thickest metal sheet (4) are of equal thickness.

**9.** Element according to one of the preceding claims, **characterized in that** it has a flat shape or a curved shape or a shape combining one or more flat parts and one or more curved parts.

**10.** Inductor (10) for inductively heating a product (2), the inductor comprising a wall (11) arranged opposite the product to be heated connected to a supply plate (12) connected to a source (13) of alternating current, **characterized in that** the wall of the inductor, and/or the supply plate, comprises an element according to one of the preceding claims.

**11.** Inductor according to the preceding claim, comprising an element according to one of claims 1 to 9 with only two metal sheets, the first metal sheet (3) being less thick than the second metal sheet (4), the element forming all or part of the wall (11) arranged opposite the product (2) to be heated,
**characterized in that** the second, thicker metal sheet (4) is arranged toward the inside of the inductor where the product to be heated will be arranged.

**12.** Induction heating apparatus (100) comprising an inductor according to one of the two preceding claims and a magnetic shield (14) around the inductor, **characterized in that** said magnetic shield comprises an element according to one of claims 1 to 9.

**13.** Induction heating apparatus (100) according to the preceding claim, wherein the inductor comprises a short-circuit coil (15) or a short-circuit plate (150), **characterized in that** said short-circuit coil or short-circuit plate comprises an element according to one of claims 1 to 9.

**14.** Induction heating apparatus (100) according to claim 12, comprising a heat sink (16), **characterized in that** said heat sink comprises an element according to one of claims 1 to 9.

**15.** Method for manufacturing an element according to one of claims 1 to 9, **characterized in that** the volume (9, 90) formed between the first (3), and/or third (30) metal sheet when said element further depends on claim 2, and the second metal sheet (4) is obtained by plastic deformation of the first, and/or third metal sheet resulting from the injection of a pressurized fluid between the two metal sheets within the contour formed by the peripheral continuous weld (6, 60).

**16.** Method according to the preceding claim, **characterized in that** annealing of the first (3), and/or of the third (30) metal sheet when the element further depends on claim 2, is carried out on at least that part of the metal sheet located, or intended to be located, within the contour formed by the peripheral continuous weld (6, 60) to be plastically deformed by the injection of a pressurized fluid.

**17.** Method according to the preceding claim, **characterized in that** the annealing is carried out after the peripheral continuous weld (6, 60) has been produced, the metal sheet being heated to the annealing temperature by the means used to produce the peripheral continuous weld (6, 60) and/or a continuous or discontinuous (8, 80) weld (800) within the contour formed by the peripheral continuous weld (6, 60), or by another heating means.

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2003047558 A